(19) Europäisches Patentamt
European Patent Office
Office européen des brevets

(11) **EP 1 557 485 A1**

(12) **EUROPEAN PATENT APPLICATION**
published in accordance with Art. 158(3) EPC

(43) Date of publication:
27.07.2005 Bulletin 2005/30

(51) Int Cl.⁷: **C30B 29/22**, H01L 39/24

(21) Application number: 03769994.9

(86) International application number:
**PCT/JP2003/013887**

(22) Date of filing: **29.10.2003**

(87) International publication number:
**WO 2004/040046 (13.05.2004 Gazette 2004/20)**

(84) Designated Contracting States:
**AT BE BG CH CY CZ DE DK EE ES FI FR GB GR HU IE IT LI LU MC NL PT RO SE SI SK TR**

(30) Priority: **31.10.2002 JP 2002318477**

(71) Applicants:
• **SUMITOMO ELECTRIC INDUSTRIES, Ltd Osaka-shi, Osaka 541-0041 (JP)**
• **International Superconductivity technology Center, The Juridical Foundation Tokyo 105-0004 (JP)**

(72) Inventors:
• **HASEGAWA, Katsuya c/o Osaka Works of Sumitomo Ltd Osaka-shi Osaka 554-8511 (JP)**

• **IZUMI, Teruo The Juridical Foundation (JP)**
• **SHIOHARA, Yuh The Juridical Foundation (JP)**
• **SUGAWARA, Yoshihiro Nagoya-shi, Aichi456-8587 (JP)**
• **HIRAYAMA, Tsukasa Nagoya-shi, Aichi456-8587 (JP)**
• **OBA, Fumiyasu Dept. of Materials Science & Eng. Kyoto-shi, Kyoto 606-8501 (JP)**
• **IKUHARA, Yuichi Bunkyo-ku, Tokyo 113-8656 (JP)**

(74) Representative: **Kreutzer, Ulrich, Dipl.-Phys. et al Cabinet Beau de Loménie, Bavariaring 26 80336 München (DE)**

(54) **METHOD FOR FORMING THIN FILM ON BASIC MATERIAL THROUGH INTERMEDIATE LAYER**

(57) The invention relates to a technique for forming a thin film of good quality on a base substance via an intermediate layer. Such a film formation technique is suitably applicable to formation of an oxide high-temperature superconductor thin film usable for a superconducting wire material, a superconducting device or the like.

In the method of forming a thin film on a base substance via an intermediate layer, an interface energy Ea at an interface A between the base substance and the intermediate layer, an interface energy Eb at an interface B between the intermediate layer and the thin film, and an interface energy Ec at an interface C between the base substance and the thin film in a state where the intermediate layer is omitted are calculated, and then a substance for the intermediate layer is selected so as to satisfy conditions of Ea<Ec and Eb<Ec.

FIG.3A

FIG.3B

## Description

Technical Field

The present invention relates to a technique for forming a thin film of good quality on a base substance via an intermediate layer. Such a film formation technique is preferably applicable to formation of an oxide high-temperature superconductor thin film usable, e.g., for a superconducting wire material or a superconducting device.

Background Art

Oxide high-temperature superconductors have been expected to be practically applied to superconducting electromagnets, superconducting cables, superconducting devices and others, because they have their critical temperatures higher than the liquid nitrogen temperature and do not require the very low temperature of liquid helium. Accordingly, various studies have been in progress for the oxide high-temperature superconductors.

For a using manner of an oxide high-temperature superconductor, a superconductor thin film has attracted attention, since it exhibits a high critical current density and can be made with a large area. To form an oxide high-temperature superconductor thin film, however, it is necessary to use a base substance having sufficient strength for supporting the thin film. The high critical current density can be obtained only when a single crystalline thin film of oxide high-temperature superconductor is formed by epitaxial growth on such a base substance. That is, it is important to select a base substance suitable for epitaxial growth of the thin film thereon to ensure formation of an oxide high-temperature superconductor thin film exhibiting a high critical current density.

When a single crystal substrate is used for the base substance, in a conventional method of selecting the substrate, attention has primarily been paid such that there is only a small difference in lattice constant between the substrate and a thin film to be formed thereon (see Solid State Commu., Vol. 98, 1996, pp. 157-161). Similarly, in the case that a thin film is to be formed on a substrate via an intermediate layer, in a conventional method of selecting the intermediate layer, special emphasis has been placed on the small difference in lattice constant between the intermediate layer and the thin film formed thereon (see Physica C, Vol. 357-360, 2001, pp. 1358-1360).

As described above, it is generally preferable that the lattice constant difference between a substrate and a thin film to be epitaxially grown thereon is as small as possible. However, there is a case that a substance having a large difference in lattice constant with respect to an objective thin film to be formed is desired to be used for a base substance for formation of the thin film, from the standpoints of high strength, high crystal orientation, low cost and low permittivity. For example, it may be desired to use MgO for a base substance for growing a thin film of RE 123 thereon. In such a case, it is necessary to grow the objective thin film of good quality on the base substance despite the large difference in lattice constant between RE123 and MgO. Herein, RE123 represents a rare earth oxide superconductor of $RE_{1+x}Ba_{2-x}Cu_3O_{7-y}$, where RE represents at least one kind of rare earth elements such as Sm, Y and Nd.

In the case that there is a large lattice constant difference between a base substance and an objective thin film to be formed, it is normally attempted to insert an intermediate layer between the base substance and the thin film, as described above. In the case of selecting a substance for the intermediate layer, conventionally, only the lattice constant difference at the interface has been taken into account. When the substance for the intermediate layer is selected to ensure lattice match between the thin film and the intermediate layer, however, lattice match between the intermediate layer and the base substance would be degraded. Conversely, when lattice match between the intermediate layer and the base substance is ensured, lattice match between the thin film and the intermediate layer would be degraded, in which case there would be no point in inserting the intermediate layer. It is, therefore, considered that it is insufficient to take account of only the lattice constant difference regarding selection of a substance for the intermediate layer.

Disclosure of the Invention

In view of the above-described situations of the conventional art, an object of the present invention is to provide a method of forming an objective thin film on a base substance via an intermediate layer, enabling more appropriate selection of a substance for the intermediate layer and ensuring formation of the thin film of a better quality.

According to the present invention, a method of forming a thin film on a base substance via an intermediate layer includes the steps of calculating an interface energy Ea at an interface A between the base substance and the intermediate layer as well as an interface energy Eb at an interface B between the intermediate layer and the thin film; calculating an interface energy Ec at an interface C between the base substance and the thin film in a state where the intermediate layer is omitted; selecting a substance for the intermediate layer so as to satisfy conditions of Ea<Ec and Eb<Ec.

Preferably, each of the interface energies Ea and Eb is lower than 2 $J/m^2$. After an energy Ed of a crystal including the interface and an energy Ep of a perfect crystal taking account of chemical potentials of constituent elements are calculated by the first-principles calculation band method, each of the interface energies Ea, Eb and Ec can be calculated as Ed - Ep.

Still preferably, in at least one of the interfaces A and B, substances on both sides of the interface share a specific atomic layer contained in common therein, to thereby reduce the interface energy. Further, at least one of the interfaces A and B can have a smaller difference in crystal lattice constant compared to the interface C, to thereby reduce the interface energy.

Preferably, the substance for the intermediate layer is an oxide having a stacked-layer crystal structure containing at least two kinds of atomic layers, wherein one kind of the atomic layers decreases the interface energy Ea compared to the interface energy Ec, and another kind of the atomic layers decreases the interface energy Eb compared to the interface energy Ec. Further, the substance for the intermediate layer preferably has a crystal structure of a perovskite type.

When the oxide as the substance for the intermediate layer includes a coordination polyhedron formed of oxygen ions surrounding a metal ion, it is preferable that in at least one of the interfaces A and B, the oxygen ions are also linked with another substance constituting the interface.

It is preferable that the base substance has a crystal structure of a rock-salt type. Preferably, the base substance is MgO, the substance for the intermediate layer is $BaZrO_3$, and the thin film is $RE_{1+x}Ba_{2-x}Cu_3O_{7-y}$) where RE represents at least one kind of rare earth elements.

Brief Description of the Drawings

Figs. 1A and 1B are lattice models of the interface of Sm123/MgO (in the case ofBa on Mg), showing states before and after relaxation, respectively.

Figs. 2A and 2B are lattice models of the interface of Sm123BZO, showing states before and after relaxation, respectively.

Figs. 3A and 3B are graphs showing the amount of displacement from the atomic site of a perfect crystal, showing the case of the interface of Sm 123/MgO (Ba on Mg) and the case of the interface of Sm 123/BZO, respectively.

Best Modes for Carrying Out the Invention

With respect to a MgO single crystal base substance (or a MgO single crystalline film base substance that is in-plane oriented by the "tilted substrate method", see Japanese Patent Laying-Open No. 7-291626) and a Sm123 thin film, the inventors have found that insertion of BZO (herein, BZO refers to $BaZrO_3$) as an intermediate layer has an effect to improve in-plane crystal orientation in the Sm123 film. The inventors have further suggested (see J. Japan Inst. Metals, Vol. 66, 2002, pp. 320-328) that a factor of such an effect can be explained by introducing the concept of interface energy between different kinds of substances taking account of crystal structures of those substances.

In addition, the inventors have pointed out a possibility that at the interface of epitaxially grown Sm123/BZO, an atomic layer BaO contained in common in the substances on both sides of the interface may be shared by the substances. Further, the inventors have considered that, when the interface is formed of an atomic layer common to the substances on both sides thereof, the chemical factor of the interface energy would be reduced, leading to improved epitaxy.

To date, however, the analysis has been limited to qualitative discussion, and a method of selecting a preferable candidate substance from a great number of substances for an intermediate layer has not been generalized yet. More specifically, with the conventional art, it is not possible to quantify the interface energy at the interface between different kinds of substances. Possible increase/decrease of the interface energy has merely been pointed out for only the interface of Sm123/BZO/MgO substance system, as shown in J. Japan Inst. Metals, Vol. 66, 2002, pp. 320-328. To the best knowledge of the inventors, there has been no report in which an interface energy was quantified for an interface between different kinds of substances including a substance of a complicated structure such as high-temperature superconductor. The reason why BZO has been selected for the intermediate layer in the above-described substance system is only that BZO is stable with respect to the highly reactive molten Ba-Cu-O (see Japanese Patent Laying-Open No. 2000-299026). At the time when BZO was selected for the intermediate layer, it was unclear even whether a RE 123 film could be epitaxially grown thereon.

It has been found in the present invention that the interface energy even in a complicated substance system can be quantified by using the first-principles calculation band method as a calculation method of the interface energy. It was found that the calculated result of the interface energy agreed well with the experimental result shown in J. Japan Inst. Metals, Vol. 66, 2002, pp. 320-328. It was also found that, at the interface, each atom in the crystal structure of single substance suffers displacement from its ideal site and then the degree of this displacement was correlated with the magnitude of the interface energy. This is not only able to explain the experimental results for the substance system of Sm123/BZO/MgO, but also means that, in the case of setting an unknown interface in the future, the interface energy can be calculated to allow selection of preferable candidate substances for the intermediate layer in advance. At the time of designing a stacked-layer structure including a plurality of substances, therefore, the present invention can provide highly effective means for obtaining a stacked-layer structure of a good quality.

<Calculation of interface energy by first-principles calculation>

(First-principles calculation band method)

The method employed is called a band calculation method of the first-principles calculation that is suitable for handling problems of solid substances. The method has the following features of (a) through (d) (for detailed explanation of this method, see the text for The 2001 Seminar of Japan Institute of Metals, titled "Material Engineering for Studying with Personal Computer", pp. 21-31).

(a) Information necessary for the calculation method includes atomic numbers and initial atomic sites (crystal structure), while experimental values and empirical parameters are not needed.
(b) In the process of calculation, positional variations of constituent atoms, electron states, and energies are calculated repeatedly to optimize the structure such that the system energy is minimized.
(c) The obtainable results can include an atomic arrangement, a lattice constant, a formation enthalpy, an interface structure, an interface energy, an electron state and others.
(d) Limitations imposed on the calculation method include the absolute zero point, a periodic boundary condition, and the number of atoms up to about 100 within a unit cell.

If desired, validity of the calculated results can be checked by comparing the calculated values and the experimental values available. In the course of making the present invention, calculation was carried out regarding a perfect crystal of each single substance prior to attending to the problems of the interface, and the calculated results were compared with the experimental values. For each of Sm123, BZO and MgO, the calculated result of lattice constant agreed with the experimental value with a difference within about 1%. Further, in Sm123 having a complicated crystal structure, the calculated atomic arrangement (positional coordinates of each atom in the unit cell in which each ofBa and Cu constitutes the same atomic layer with O but is not in the same plane with O) agreed with the experimental value with a difference within about 2% (see Jpn. J. Appl. Phys., Vol. 34, 1995, pp. 6031-6035). As described above, it is possible to obtain calculated results for a perfect crystal of a single substance. Description will now be given for handling of a system including an interface.

(Setting of interface model)

To carry out calculations for an interface of interest, firstly, it is necessary to make a model of atomic structure of the interface. Although a fundamental unit cell of crystal structure may be employed for a perfect crystal of a single substance, in the case of an interface, an expanded cell (super cell) is constructed from the fundamental unit cell. At this time, there are the above-described limitations (d) of the periodic boundary condition and the number of atoms up to about 100 within the unit cell (within capability of the computer used in the analysis). Therefore, it was necessary to consider the following measures.

Specifically, since Sm123 has a lattice constant difference of about 8% at the interface with each of MgO and BZO, the lattice constant of Sm123 was adjusted to that of MgO or BZO (more specifically, the a-axis length of the Sm123 lattice was extended by about 8% for optimization of the structure). This makes it possible to impose the periodic boundary condition with the same number of atoms as that in the unit cell of the single substance in directions parallel to the interface. In a direction perpendicular to the interface, a structure including two interfaces symmetrical to each other in upper and lower directions was employed to reduce the time required for calculation. In this structure, the single substance layer at the center was made to have a thickness corresponding to several atomic layers so as to reduce interaction between the two interfaces. As such, the number of atoms in the cell was restricted within about 100.

If the lattice constants of respective substances are used without the modification, 12-13 unit cells are needed to make the lattices of the substances have a common period in the directions parallel to the interface, according to estimation from the lattice constant difference. In such a case, the number of atoms in the super cell increases to about 150 times corresponding to the square of the enlarged period, which makes it necessary to use an extremely large computer and makes the calculation impractical. As described above, since the lattice constants of the substances are matched at the interface in the process of calculation, the calculation can substantially be regarded as computation of the chemical factor of the interface energy of the Sm123/BZO/MgO substance system. In other words, by considering the geometrical factor and the chemical factor separately in the interface energy, it is possible to carry out analysis of the system having the large lattice constant difference between the substances.

Atomic plane structures at the termination planes of substances forming the interface are critical for the interface energy. The unit cell of Sm123 is formed of six atomic layers, which means that there are six possible atomic layers coming into contact with MgO. It may be possible to carry out calculations for all the possible layers. However, in view of a report on cross-sectional TEM (transmission electron microscopy) observation of a similar system of Y123/MgO interface having the BaO plane as the termination plane on the Y123 side (see The Fourth Pacific Rim International Conference on Advanced Materials and Processing, 2001, pp. 729-732, The Japan Institute of Metals), the present embodiment adopted the lattice structures having the stacking sequences as follows (a mark + means an interface having been set):

for Sm123/MgO: bulk (MgO) - MgO plane + BaO plane - CuO plane - BaO plane - bulk (Sm123); and
for Sm123/BZO: bulk (BZO) - $ZrO_2$ plane + BaO plane - CuO plane - BaO plane - bulk (Sm123).

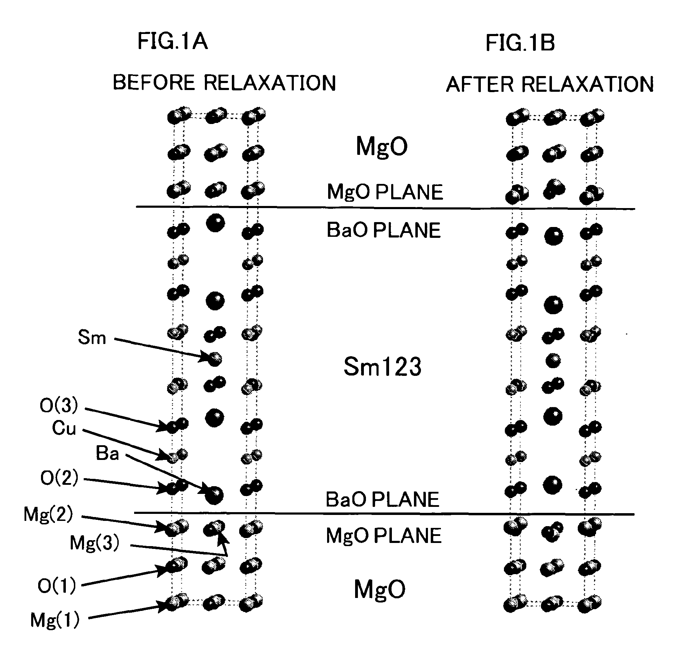

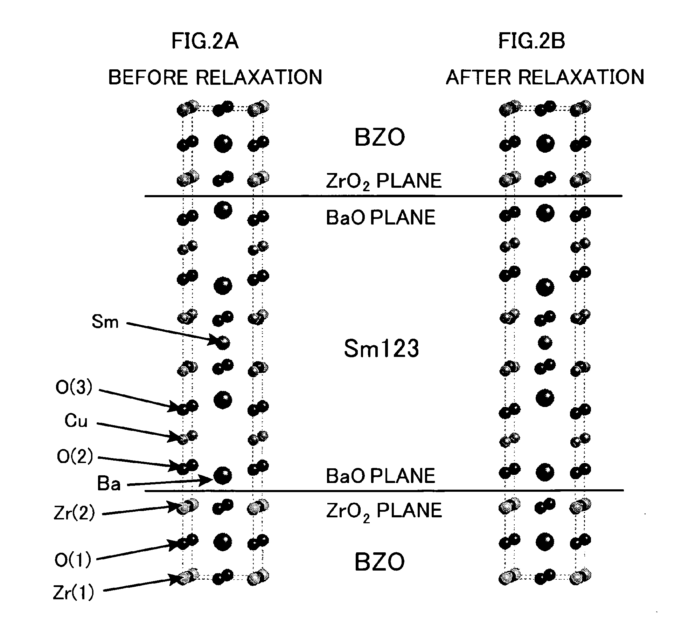

While RE123 includes two different BaO planes in its stacked-layer structure, the one in which the CuO chain plane resides immediately on the BaO was adopted as the interface in the present embodiment. Further, it was considered that, by selecting the $ZrO_2$ plane as the termination plane on the BZO side at the interface of Sm123/BZO, it would be possible to comparatively evaluate the interface energies when only the substratum under Sm123 was changed from MgO to BZO or vice versa. The atomic arrangement of the BaO plane as the termination plane on the Sm123 side was shifted by a half of the lattice constant in the interface, to calculate both the case ofBa residing immediately on Mg (referred to as "Ba on Mg") and the case ofBa on O (referred to as "Ba on O"). It was supposed at the interface of Sm123/BZO that Ba in the termination plane of Sm123 is on the same axis as Ba in BZO of the underlayer (referred to as "Ba in BZO"). An interval between the atomic planes (half the lattice constant: about 0.21 nm) of MgO or BZO was used as the initial value for the spacing at the interface. The super cells including the interfaces thus formed are shown in Figs. 1A and 2A. Fig. 1A shows the interface of Sm123/MgO (with Ba on Mg), and Fig. 2A shows the interface of Sm123/BZO.

(Introduction of necessary formula)

The interface energy is defined as "excessive energy due to presence of an interface" in the thermodynamics. When the interface is regarded as a kind of lattice defect, the interface energy can be expressed by the following general expression (1) related to formation energy Ef of the defect:

$$Ef = Ed - Ep \qquad (1)$$

where Ed represents energy of the crystal including the defect, and Ep represents energy of a perfect crystal. A cell (super cell) obtained by expanding the fundamental unit cell is used for calculation of Ed. In the case of the interface between different kinds of compounds as in the present embodiment, information of chemical potential $\mu$ is required for calculation of the interface energy, as described in the following.

In the case of a pure substance, when the number of constituent atoms is represented as n, the following expression holds:

$$Ep = \mu n \qquad (2)$$

By calculating Ep, $\mu$ can be obtained as energy per atom. In the case of a compound, on the other hand, when chemical potential for a component i is represented as $\mu_i$ and the number of atoms is represented as $n_i$, the following expression holds:

$$Ep = \Sigma \mu_i n_i \qquad (3)$$

in which case $\mu_i$ is a variable dependent on the composition element.

In the calculation model of the present embodiment, expression (1) can be expanded in the case of Sm123/MgO interface, as follows:

$$Ef = 1/2 \ (Ed - \Sigma\mu_i n_i\} \tag{4}$$

$$= 1/2 \ \{E_{SmBa4Cu4Mg10O18} - (\mu_{Sm} + 4\mu_{Ba} + 4\mu_{Cu} + 10\mu_{Mg} + 18\mu_o)\} \tag{5}$$

$$= 1/2 \ \{E_{SmBa4Cu4Mg10O18} - E_{SmBa2Cu3O6} - 10E_{MgO} - (\mu_{Cu} + 2\mu_{Ba} + 2\mu_o)\} \tag{6}$$

In the above expressions (4)-(6), coefficient 1/2 is multiplied since the super cell includes two interfaces.

Expression (5) utilizes the relation in which elements of the same kind existent in a plurality of phases under a thermal equilibrium state have the same chemical potential, which can be expressed as:

$$\mu_o = \mu_o \text{ in Sm123} = \mu_o \text{ in MgO} \tag{7}$$

Further, the expression (6) is rearranged using the relations of the following expressions (8) and (9):

$$\mu_{Sm} + 2\mu_{Ba} + 3\mu_{Cu} + 6\mu_o = \mu_{SmBa2Cu3O6} = E_{SmBa2Cu3O6} \tag{8}$$

$$\mu_{Mg} + \mu_o = \mu_{MgO} = 10E_{MgO} \tag{9}$$

In the expression (6), although the first, second and third terms can be obtained with the first-principles band calculation method, there remain unknown values for the chemical potentials in the fourth term. Even if the number of layers of Sm123 is increased in the super cell, the fourth term always remains as the excessive energy at the interface, which is an important factor for calculation of the interface energy. To obtain ranges of $\mu_{Cu}$, $\mu_{Ba}$ and $\mu_o$, it is also necessary to consider the thermal equilibrium conditions as follows (for example, an expression (12) corresponds to a condition that there is no precipitation of BaO):

$$\mu_{Cu} + \mu_o < \mu_{Cuo} \tag{10}$$

$$2\mu_{Cu} + \mu_o < \mu_{Cu2O} \tag{11}$$

$$\mu_{Ba} + \mu_o < \mu_{BaO} \tag{12}$$

In the present embodiment, as a first stage, the sign "<" in each of expressions (10), (11) and (12) is approximated to a sign "=". This corresponds to a condition in which precipitates of CuO, $Cu_2O$ and BaO can coexist, which is hereinafter referred to as a "BaO co-precipitation condition".

Similarly, for the Sm 123/BZO interface, expression (1) can be rearranged as follows:

$$Ef = 1/2 \ \{E_{SmBa6Cu4Zr3O16} - E_{SmBa2Cu3O6} - 3E_{BaZrO3} - (\mu_{Cu} + \mu_{Ba} + \mu_O)\} \tag{13}$$

Here, again, the chemical potentials of Ba, Cu and O remain unknown, and thus approximation was done with the BaO co-precipitation condition similarly as in the case of the Sm123/MgO interface.

(Calculated results)

Among the results of calculation, the interface energy values are shown in Table 1. As seen from Table 1, the interface energy of Sm123/BZO is 0.79 J/m$^2$, which is about 1/3 of that of Sm123/MgO, causing a considerable difference therebetween.

Table 1:

| Results of Calculation of Interface Energy (BaO Co-precipitation Condition) | | |
|---|---|---|
| Constitution of interface | Atomic arrangement at interface | Interface energy ($J/m^2$) |
| Sm123/MgO | Ba on Mg | 2.25 |
| Sm123/MgO | Ba on O | 2.74 |
| Sm123/BZO | Ba in BZO | 0.79 |
| BZO/MgO | Zr on O | 1.12 |

Figs. 1B and 2B show states after relaxation of the atomic structures at the Sm123/MgO interface (Ba on Mg) and the Sm123/BZO interface, respectively, optimized by the first-principles calculation. As seen from comparison between the atomic structures at the interface before and after relaxation, in the case of Sm123/MgO, ions of the same sign ($Mg^{2+}$ within MgO and $Ba^{2+}$ within Sm123) considerably relax so as to avoid being too close to each other at the interface (i.e., great strain is caused at the interface compared to the original perfect crystal).

By comparison, in the case of Sm123BZO, relaxation occurs such that Ba and O on the BaO plane at the interface are approximately in the same plane, and the interval between the atomic planes at the interface after the relaxation is close to that of the perfect crystal of BZO. That is, in the stable structure obtained after setting the initial atomic sites, the Ba layer at the termination plane of Sm123 becomes almost equivalent to the BaO layer in BZO, and it is neatly aligned with the $ZrO_2$ plane as if it were the BaO plane of BZO. In other words, it can be considered that Sm123 and BZO share the BaO layer at their interface.

Displacement of an atomic site in the vicinity of the interface was defined by the following expression (14) on the basis of the atomic site in the perfect crystal, to numerically express the degree of strain from the perfect crystal:

$$\text{Displacement from atomic site in perfect crystal (\%)} = \{(\text{distance between atoms after relaxation - distance between atoms before relaxation)} / \text{distance between atoms before relaxation}\} \times 100 \qquad (14)$$

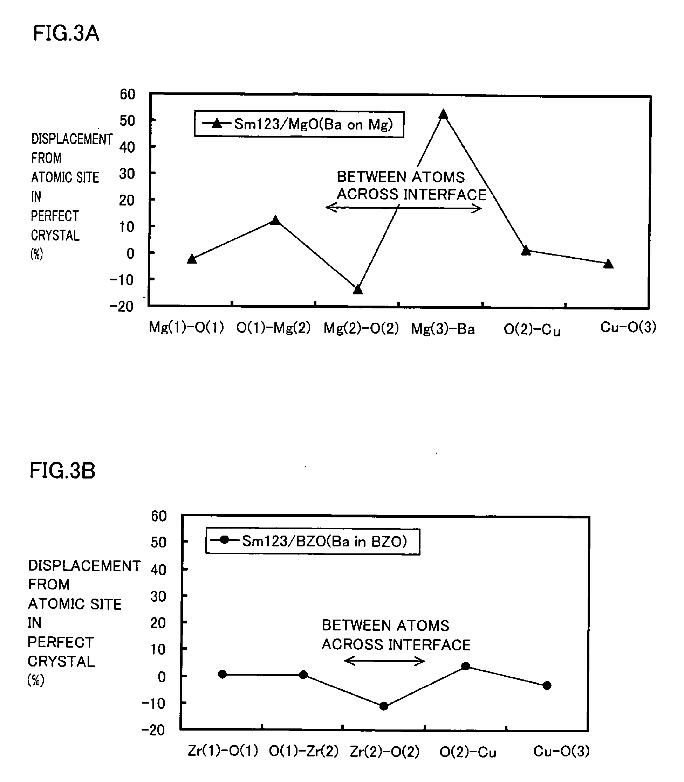

Figs. 3A and 3B are graphs showing the degrees of strain at the interfaces of Sm123/MgO and Sm123/BZO, respectively. In each graph, a horizontal axis represents the pairs of atoms shown with arrows in Figs. 1A, 1B, 2A and 2B, and a vertical axis represents their displacement. While the displacement in the vicinity of the interface of Sm123/MgO is large in a range from -13% to 53%, the displacement at the interface of Sm123/BZO is small in a range from -11% to 4.1%. In the case of the Sm123/BZO interface, if the position of the BaO layer at the interface is defined on the basis of the perfect crystal of BZO, the displacement becomes smaller in a range from -0.7% to 4.1%, clearly showing that there is less disturbance in the atomic structure at the interface of Sm123/BZO. It is confirmed that another Sm123/MgO interface (with Ba on O) also shows considerable disturbance of the atomic structure in the interface structure. As such, the low interface energy of Sm123/BZO also corresponds to the fact that there is less disturbance in the atomic structures at the interface depicted by the first-principles calculation.

On the contrary, the calculated results for the Sm123/MgO interface show that the chemical factor of the interface energy remains large with the combination of these substances, even if their actual lattice constants match. In other words, even if a substance matching in lattice constant with the objective thin film is selected for the substrate or the intermediate layer, the interface energy with respect to the thin film does not always decrease. Selection of the substance for the underlayer taking only account of the lattice constant cannot guarantee a stable structure at the interface. Therefore, it is important to consider the selecting method of the substance for the intermediate layer as explained in the present invention.

Similarly as the above, the interface energy can be calculated for a BZO/MgO interface, too. A model of the relevant interface and calculated results of the interface energy are now described in brief. From the crystal structures of the respective substances, the stacking sequence of layers was set as follows:

for BZO/MgO: bulk (MgO) - MgO plane + $ZrO_2$ plane - bulk (BZO),

and the atomic arrangement in the interface was set such that Zr in BZO resides immediately on O in MgO (Zr on O). The calculated result of the interface energy was as small as 1.12 $J/m^2$, which is also shown in Table 1. It is also confirmed in an optimal structure derived from the interface model that there are only small displacements from ideal atomic sites in the perfect crystal of the single substance.

As described above, it has been shown that it is possible by using the first-principles calculation to calculate the interface energy which has been considered as a factor for improving epitaxy of the Sm123 film on the MgO base substance by the BZO intermediate layer interposed therebetween, and it has been found that the calculated results agree with the experimental results shown in the above-described article of J. Japan Inst. Metals, Vol. 66 (2002), pp. 320-328.

<Summary and Development>

The interface energies were quantified for the interfaces of different kinds of complicated compounds of Sm123/MgO and Sm123/BZO. When the factor of excessive chemical potential at the interface was approximately calculated on the BaO co-precipitation condition, the interface energy of Sm123/BZO was 0.79 $J/m^2$, and the interface energy of BZO/MgO was 1.12 $J/m^2$, which were sufficiently smaller than the interface energy of Sm123/MgO of 2.25 $J/m^2$ or 2.74 $J/m^2$.

These calculated results agree with the experimental results indicating that the selection of BZO as a substance for the intermediate layer on the MgO substrate can improve epitaxy of Sm123. As such, supposing a stacked-layer structure including an intermediate layer with consideration of atomic layers, when calculations are carried out for an interface energy Ea between the intermediate layer and the base substance, an interface energy Eb between the objective thin film and the intermediate layer, and an interface energy Ec between the thin film and the base substance in the stacked-layer structure from which the intermediate layer has been taken out, it can be determined that the intermediate layer satisfying both Ea < Ec and Eb < Ec matches both the thin film and the base substance.

BZO selected herein as a substance for the intermediate layer can reduce the interface energies with both the base substance MgO and the thin film Sm123. The $ZrO_2$ layer in BZO plays an important role for MgO, while the BaO layer in BZO plays an important role for Sm123. In general, therefore, paying attention to compounds each of which includes at least two kinds of atomic layers, it is preferable to calculate the interface energies with respect to intermediate layers each of which includes an atomic layer assumed to reduce the interface energy with both the objective thin film and the base substance.

The inventors had expected from their crystallographic consideration that BZO having the perovskite type structure and MgO having the rock-salt type structure would be able to form a continuous interface structure. In the present embodiment, it has become possible to quantify the smallness of the interface energy of such an interface structure. As a way of reducing the interface energy, therefore, when the oxide is considered as a coordination polyhedron formed of oxygen ions surrounding a metal ion, it is preferable to use a combination of oxide substances permitting linkage of oxygen atoms at the apexes of the coordination polyhedrons across the interface.

As a development of the present embodiment, with respect to the factor of excessive chemical potential approximated at the interface, it is possible to carry out calculations for other various compounds able to coexist as precipitates, in order to narrow the range of the possible chemical potential for each atom and increase the degree of precision in the value of the interface energy.

In the present embodiment, the lattice constants have been matched in the process of calculation of the interface energy. Although the calculation of the interface energy is still insufficient in terms of the geometrical factor of the interface energy associated with lattice mismatch or in terms of the total interface energy including the geometrical factor, application of the contents provided in the present embodiment will make it possible to calculate the total interface energy in the following manner, for example. It is considered that the in-plane geometrical arrangement at an actual interface is gradually deviated due to the difference in lattice constant. In the present embodiment, for the interface of Sm123/MgO, calculations were carried out regarding the two cases with the atomic arrangement in the interface shifted by half the unit cell from each other. Similarly, a plurality of interface models can be set for representative cases with the atomic arrangement in the interface shifted from each other, and the calculated results of the interface energy can be averaged depending on their expected frequency.

In the present embodiment, the interface energy has been obtained using only the first-principles calculation band method. However, thermodynamic data may be incorporated as desired in the calculating process of the first-principles calculation band method, if they are applicable to the calculation of the interface energy. Besides the first-principles calculation band method, a calculation method empirically supposing potentials, for example, may be employed for making calculations for a super cell including a larger number of atoms.

Industrial Applicability

As described above, according to the present invention, it is possible to provide a method of forming a thin film on a base substance via an intermediate layer, enabling more appropriate selection of a substance for the intermediate layer and ensuring formation of the thin film of a better quality.

**Claims**

1. A method of forming a thin film on a base substance via an intermediate layer, comprising the steps of:

   calculating an interface energy Ea at an interface A between said base substance and said intermediate layer and an interface energy Eb at an interface B between said intermediate layer and said thin film;
   calculating an interface energy Ec at an interface C between said base substance and said thin film in a state where said intermediate layer is omitted; and
   selecting a substance for said intermediate layer so as to satisfy conditions of Ea<Ec and Eb<Ec.

2. The thin film forming method according to claim 1, wherein each of said interface energies Ea and Eb is lower than $2 \text{ J/m}^2$.

3. The thin film forming method according to claim 1, wherein after calculating an energy Ed of a crystal including the interface and an energy Ep of a perfect crystal taking account of chemical potentials of constituent elements by the first-principles calculation band method, each of said interface energies Ea, Eb and Ec is calculated as Ed - Ep.

4. The thin film forming method according to claim 1, wherein in at least one of said interfaces A and B, substances on both sides of the interface share a specific atomic layer contained in common therein, to thereby reduce the interface energy.

5. The thin film forming method according to claim 1, wherein at least one of said interfaces A and B has a small difference in crystal lattice constant compared to said interface C, to thereby reduce the interface energy.

6. The thin film forming method according to claim 1, wherein said substance for said intermediate layer is an oxide having a stacked-layer structure containing at least two kinds of atomic layers, wherein one kind of said atomic layers decreases said interface energy Ea compared to said interface energy Ec, and another kind of said atomic layers decreases said interface energy Eb compared to said interface energy Ec.

7. The thin film forming method according to claim 1, wherein said substance for said intermediate layer has a crystal structure of a perovskite type.

8. The thin film forming method according to claim 6, wherein, when said oxide as said substance for said intermediate layer includes a coordination polyhedron formed of oxygen ions surrounding a metal ion, in at least one of said interfaces A and B, the oxygen ions are also linked with another substance constituting the interface.

9. The thin film forming method according to claim 6, wherein said base substance has a crystal structure of a rock-salt type.

10. The thin film forming method according to claim 1, wherein said base substance is MgO, said substance for said intermediate layer is $BaZrO_3$, and said thin film is $RE_{1+x}Ba_{2-x}Cu_3O_{7-y}$ where RE represents at least one kind of rare earth elements.

FIG.1A

BEFORE RELAXATION

FIG.1B

AFTER RELAXATION

MgO

MgO PLANE

BaO PLANE

Sm123

Sm

O(3)

Cu

Ba

O(2)

BaO PLANE

Mg(2)

MgO PLANE

Mg(3)

O(1)

MgO

Mg(1)

FIG.2A
BEFORE RELAXATION

FIG.2B
AFTER RELAXATION

BZO

ZrO₂ PLANE

BaO PLANE

Sm123

Sm

O(3)

Cu

O(2)

Ba

BaO PLANE

Zr(2)

ZrO₂ PLANE

O(1)

BZO

Zr(1)

FIG.3A

FIG.3B

EP 1 557 485 A1

## INTERNATIONAL SEARCH REPORT

| International application No. |
| --- |
| PCT/JP03/13887 |

**A. CLASSIFICATION OF SUBJECT MATTER**
Int.Cl$^7$ C30B29/22, H01L39/24

According to International Patent Classification (IPC) or to both national classification and IPC

**B. FIELDS SEARCHED**

Minimum documentation searched (classification system followed by classification symbols)
Int.Cl$^7$ C30B29/22, H01L39/24

Documentation searched other than minimum documentation to the extent that such documents are included in the fields searched
Jitsuyo Shinan Koho 1922–1996 Toroku Jitsuyo Shinan Koho 1994–2004
Kokai Jitsuyo Shinan Koho 1971–2004 Jitsuyo Shinan Toroku Koho 1996–2004

Electronic data base consulted during the international search (name of data base and, where practicable, search terms used)
WPI, JSTPlus(JOIS)

**C. DOCUMENTS CONSIDERED TO BE RELEVANT**

| Category* | Citation of document, with indication, where appropriate, of the relevant passages | Relevant to claim No. |
| --- | --- | --- |
| X | Katsuya HASEGAWA et al., "Laser Jochakuho ni yoru SmBa$_2$Cu$_3$O$_y$ Maku no Sakusei to sono Men'nai Haikosei Kojo", Nippon Kinzoku Gakkaishi, 20 April, 2002 (20.04.02), Vol.66, No.4, pages 320 to 328; page 326, left column, line 23 to page 327, right column, line 34 | 1–10 |
| A | US 5607899 A (SUMITOMO ELECTRIC INDUSTRIES LTD.), 04 March, 1997 (04.03.97), & JP 7-291626 A & EP 669411 A2 | 1–10 |

| ☐ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 06 January, 2004 (06.01.04) | 20 January, 2004 (20.01.04) |

| Name and mailing address of the ISA/ | Authorized officer |
| --- | --- |
| Japanese Patent Office | |
| Facsimile No. | Telephone No. |

Form PCT/ISA/210 (second sheet) (July 1998)

13